# EUROPEAN PATENT SPECIFICATION

(11) **EP 3 882 944 B1**
(45) Date of publication and mention of the grant of the patent: **22.06.2022**
(21) Application number: 20163833.5
(22) Date of filing: 18.03.2020
(51) Int. Cl.: H01H 39/00, G01R 31/327

(54) **PYRO IGNITER CIRCUIT AND TESTING METHOD**
PYROZÜNDERSCHALTUNG UND TESTVERFAHREN
CIRCUIT PYRO-ALLUMEUR ET PROCÉDÉ D'ESSAI

(43) Date of publication of application: 22.09.2021
(73) Proprietor: Samsung SDI Co., Ltd., Gyeonggi-do 17084 (KR)
(72) Inventor: Erhart, Michael, 8054 Pirka-Seiersberg (AT); Reinprecht, Wolfgang, 8144 Attendorf (AT)
(74) Representative: Gulde & Partner

(56) References cited:
- EP-A2- 1 531 535
- WO-A1-88/02491
- WO-A1-2006/117550
- DE-A1-102012 214 835
- US-A1- 2018 147 941
- US-A1- 2018 284 193

## Description

### Field of the Invention

The present invention relates to a pyro igniter circuit and a testing method for testing a pyro igniter circuit. Further, a battery system comprising the pyro igniter circuit and an electrical vehicle with such a battery system is disclosed.

### Technological Background

In recent years, vehicles for transportation of goods and peoples have been developed using electric power as a source for motion. An electric vehicle is an automobile that is propelled by an electric motor, using energy stored in rechargeable batteries. The electric vehicle may be solely powered by batteries or may be a form of hybrid vehicle powered by for example a gasoline generator. Furthermore, the vehicle may include a combination of electric motor and conventional combustion engine. In general, an electric-vehicle battery (EVB) or traction battery is a battery used to power the propulsion of battery electric vehicles (BEVs). Electric-vehicle batteries differ from starting, lighting, and ignition batteries because they are designed to give power over sustained periods of time. A rechargeable or secondary battery differs from a primary battery in that it can be repeatedly charged and discharged, while the latter provides only an irreversible conversion of chemical to electrical energy. Low-capacity rechargeable batteries are used as power supply for small electronic devices, such as cellular phones, notebook computers and camcorders, while high-capacity rechargeable batteries are used as the power supply for hybrid vehicles and the like.

In general, rechargeable batteries include an electrode assembly including a positive electrode, a negative electrode, and a separator interposed between the positive and negative electrodes, a case receiving the electrode assembly, and an electrode terminal electrically connected to the electrode assembly. An electrolyte solution is injected into the case in order to enable charging and discharging of the battery via an electrochemical reaction of the positive electrode, the negative electrode, and the electrolyte solution. The shape of the case, e.g. cylindrical or rectangular, depends on the battery's intended purpose. Lithium-ion (and similar lithium polymer) batteries, widely known via their use in laptops and consumer electronics, dominate the most recent group of electric vehicles in development.

Rechargeable batteries may be used as a battery module formed of a plurality of unit battery cells coupled in series and/or in parallel so as to provide a high energy density, in particular for motor driving of a hybrid vehicle. That is, the battery module is formed by interconnecting the electrode terminals of the plurality of unit battery cells depending on a required amount of power and in order to realize a high-power rechargeable battery.

A battery pack is a set of any number of (preferably identical) battery modules. They may be configured in a series, parallel or a mixture of both to deliver the desired voltage, capacity, or power density. Components of battery packs include the individual battery modules, and the interconnects, which provide electrical conductivity between them.

For meeting the dynamic power demands of various electrical consumers connected to the battery system a static control of battery power output and charging is not sufficient. Thus, steady exchange of information between the battery system and the controllers of the electrical consumers is required. This information includes the battery systems state of charge (SoC), potential electrical performance, charging ability and internal resistance as well as actual or predicted power demands or surpluses of the consumers.

Battery systems usually comprise a battery management system (BMS) and/or battery management unit (BMU) for processing the aforementioned information. The BMS/BMU may communicate to the controllers of the various electrical consumers via a suitable communication bus, e.g. a SPI or CAN interface. The BMS/BMU may further communicate with each of the battery submodules, particularly with a cell supervision circuit (CSC) of each battery submodule. The CSC may be further connected to a cell connection and sensing unit (CCU) of a battery submodule that interconnects the battery cells of the battery submodule.

Thus, the BMS/BMU is provided for managing the battery pack, such as by protecting the battery from operating outside its safe operating area, monitoring its state, calculating secondary data, reporting that data, controlling its environment, authenticating it and/or balancing it.

In case of severe fault conditions, the battery should be disconnected or shut down immediately to prevent uncontrolled heat or even fire. In battery systems, pyro igniter elements or in other words pyro-fuses can be used which cut the power line based on an ignition control signal that is generated in response to a detected severe fault condition. The cutting of the power line by the pyro igniter element is conventionally performed by a rapid pyro reaction which requires and activation.

DE102012214835 A1 discloses a pyro igniter circuit according to the preamble of claim 1.

According to the state of the art, pyro igniter circuits comprise integrated diagnosis systems which supervise the amplifying comparators and the release/activation circuit of the pyro igniter element. Current solutions consist of checking the internal integrity of the control circuit in terms of functionality rather than the complete circuit loop to fire the pyro-fuse element.

It is thus an object of the present invention to overcome or reduce at least some of the drawbacks of the prior art and to provide a pyro igniter circuit that allows for a thorough and complete check of the entire pyro igniter circuit.

### Summary of Invention

Embodiments of the present disclosure seek to solve at least one of the problems existing in the prior art to at least some extent. In particular, a pyro igniter circuit is provided, comprising: a shunt resistor electrically connected in series with a power line. The circuit further comprises an amplifier comprising inputs electrically connected to terminals of the shunt resistor and a pyro igniter disconnect element electrically connected to an output of the amplifier and configured to cut the power line based on an ignition control signal received from the output of the amplifier. The circuit further comprises a coupling resistor electrically interconnected between an input of the amplifier and a terminal of the shunt resistor. The circuit further comprises a supervisory circuit electrically connected to a node interconnected between an input of the amplifier and the coupling resistor, configured to: transmit a test signal to the node, wherein the test signal comprises a pulse duration time below an igniter activation pulse time of the pyro igniter disconnect element and/or the ignition control signal in response to the transmitted test signal comprises an amplitude below an igniter activation amplitude of the pyro igniter disconnect element, and receive a diagnostic response signal in response to the transmitted test signal.

A supervisory circuit may be an integrated part of a microcontroller or may be separately provided. The amplifier may be in other words an amplifying comparator. The amplifier amplifies a signal transmitted to the inputs of the amplifier. The coupling resistor has the function to provide a voltage drop or in other words a voltage offset at one input of the amplifier in response to the transmitted test signal. The test signal may be a voltage signal or a current signal. For example, a current signal causes a voltage drop at the coupling resistor. The coupling resistor may be in other words a test resistor. The receiving of the diagnostic response signal may be performed with a short time delay or in other words time window after the transmission of the test signal. The pyro igniter disconnect element may comprise passive or active electronic elements. For example, the pyro igniter disconnect element may comprise an ignition wire or heating wire. In further embodiments, the pyro igniter disconnect element may comprise internal transistors as active electronic elements.

The invention has the advantage that when using a short enough test signal and/or a small enough signal amplitude, the pyro igniter disconnect element is not activated or in other words not released such that the entire circuit can be checked via the transmitted test signal and received response signal. The first alternative in which the pulse duration time is below an igniter activation pulse time of the pyro igniter disconnect element is a preferred alternative since the pulse duration can be readily controlled and generated by the supervisory circuit. The alternative in which the ignition control signal in response to the transmitted test signal comprises an amplitude below an igniter activation amplitude of the pyro igniter disconnect element has to consider, when configuring the test signal, the gain of the amplifier in order to generate an ignition control signal with amplitude below an activation threshold. The alternative in which both cases are fulfilled, provides an even more reliable solution to prevent a release or activation of the pyro igniter disconnect element. Further, the testing does not interfere with the functionality of the pyro igniter circuit, since at any time an over current can activate the pyro disconnect element. Further, the testing is fast and analogue without use of a slow software interaction. Further, the test pulse is readily adjustable such that amplitude or pulse duration can be tailored and adjusted to the requirements of the underling pyro igniter circuit.

In a preferred embodiment, the supervisory circuit may be electrically connected to the output of the amplifier to receive the ignition control signal in response to the transmitted test signal. Thereby, the voltage of the ignition control signal can be tested. For example, the voltage of the ignition control signal contains information of if the amplifier has amplified the transmitted test signal correctly such that the amplifier and the amplifying function can thereby be tested by the supervisory circuit.

Preferably, the circuit may comprise a first current sensor configured to measure an electric current on an output line between the output of the amplifier and the pyro igniter disconnect element and transmit a first current signal indicative of the measured electric current to the supervisory circuit. The measured electric current provides information on if the pyro igniter disconnect element has fired already, is not connected or if an ignition wire or active electronic components of the pyro igniter disconnect element as for example internal transistors have a failure. An indication for a failure or a missing pyro igniter would be no or a very low current in response to the transmitted test signal.

In a preferred embodiment, the circuit may comprise a second current sensor configured to measure an electric current at the node in response to the transmitted test signal and transmit a second current signal indicative of the measured electric current to the supervisory circuit. The information of this electric current may be that the shunt resistor is functioning and/or electrically connected properly. Thereby the circuit part including the shunt resistor is tested. For example, when no current is detected, the shunt resistor may not be correctly connected.

Preferably, the pulse duration time may be below 20 µs, preferably below 10 µs, more preferably below 1 µs. In such cases an accidental release or activation of the pyro igniter element can be prevented. The pulse duration time may be 1/10, 1/100 or 1/1000 of the igniter activation pulse time.

In a preferred embodiment, the test signal comprises a pulse duration time below an igniter activation pulse time of the pyro igniter disconnect element and the ignition control signal in response to the transmitted test signal may comprise an amplitude above an igniter activation amplitude of the pyro igniter disconnect element. Due to the short pulse duration of the transmitted test signal, the pyro igniter disconnect element is also in this case not activated/released. The amplitude may for example be a voltage or a current amplitude.

Alternatively, the test signal comprises a pulse duration time above an igniter activation pulse time of the pyro igniter disconnect element and the ignition control signal in response to the transmitted test signal may comprise an amplitude below an igniter activation amplitude of the pyro igniter disconnect element. In such case, the amplitude is controlled such that even with longer pulse duration an activation or release of the pyro igniter disconnect element does not occur. The amplitude may be a voltage or a current amplitude.

In a preferred embodiment, the supervisory circuit may be configured to compare the received diagnostic response signal with the transmitted test signal. The comparison allows for detection of various faults in the circuitry as described above. Compare may include evaluating and verifying.

Preferably, the supervisory circuit may be configured to generate a state signal based on the comparison of the ignition control signal and the transmitted test signal. The state signal may be used as a warn signal or a control signal for disconnecting or shut down of the battery or similar purposes.

In another aspect of the invention, a testing method for testing a pyro igniter circuit is disclosed, comprising the steps: Providing a shunt resistor connected in series with a power line, an amplifier comprising inputs electrically connected to terminals of the shunt resistor, a pyro igniter disconnect element electrically connected to an output of the amplifier and configured to cut the power line based on an ignition control signal received from the output of the amplifier, a coupling resistor electrically interconnected between an input of the amplifier and a terminal of the shunt resistor. The method comprises in a further step the transmitting a test signal to a node interconnected between an input of the amplifier and the coupling resistor, wherein the test signal comprises a pulse duration time below an igniter activation pulse time of the pyro igniter disconnect element and/or the ignition control signal in response to the transmitted test signal comprises an amplitude below an igniter activation amplitude of the pyro igniter disconnect element. The method comprises in a further step the receiving a diagnostic response signal in response to the transmitted test signal.

The advantages and modalities of the corresponding test method can be inferred from the advantages provided by the pyro igniter circuit as disclosed before.

In a preferred embodiment, the pulse duration time may be below 20 µs, preferably below 10 µs, more preferably below 1 µs.

Preferably, the method comprises receiving the ignition control signal at the output of the amplifier in response to the transmitted test signal.

In a preferred embodiment, the method comprises measuring an electric current on an output line between the output of the amplifier and the pyro igniter disconnect element in response to the transmitted test signal and transmit a first current signal indicative of the measured electric current to the supervisory circuit.

Preferably, the method may comprise measuring of an electric current at the node in response to the transmitted test signal and transmit a second current signal indicative of the measured electric current to the supervisory circuit.

Preferably, the method may comprise the step of comparing the received ignition control signal with the transmitted test signal and generating a state signal based on the comparison of the ignition control signal and the transmitted test signal.

In another aspect of the invention, a battery system comprises a pyro igniter circuit according to one of the above embodiments and a plurality of battery cells electrically connected to the power line.

In another aspect of the invention, an electric vehicle comprising a battery system according to the embodiments of the invention is provided.

Further aspects of the present disclosure could be learned from the dependent claims or the following description.

### Brief Description of the Drawings

Features will become apparent to those of ordinary skill in the art by describing in detail exemplary embodiments with reference to the attached drawings in which:
Fig. 1 illustrates a schematic view of a pyro igniter circuit and a battery system according to an embodiment of the invention;
Fig. 2 illustrates a test signal pulse according to an embodiment of the invention; and
Fig. 3 illustrates schematically a testing method according to an embodiment of the invention.

### Detailed Description of the Invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. As used herein, the term "and/or" includes any and all combinations of one or more of the associated listed items. Further, the use of "may" when describing embodiments of the present invention refers to "one or more embodiments of the present invention."

In the following description of embodiments of the present invention, the terms of a singular form may include plural forms unless the context clearly indicates otherwise.

It will be further understood that the terms "include," "comprise," "including," or "comprising" specify a property, a region, a fixed number, a step, a process, an element, a component, and a combination thereof but do not exclude other properties, regions, fixed numbers, steps, processes, elements, components, and combinations thereof.

Features of the inventive concept and methods of accomplishing the same may be understood more readily by reference to the following detailed description of embodiments and the accompanying drawings. The present invention, however, may be embodied in various different forms, and should not be construed as being limited to only the illustrated embodiments herein. Rather, these embodiments are provided as examples so that this disclosure will be thorough and complete, and will fully convey the aspects and features of the present invention to those skilled in the art. Accordingly, processes, elements, and techniques that are not necessary to those having ordinary skill in the art for a complete understanding of the aspects and features of the present invention may not be described. Unless otherwise noted, like reference numerals denote like elements throughout the attached drawings and the written description, and thus, descriptions thereof will not be repeated. In the drawings, the relative sizes of elements, layers, and regions may be exaggerated for clarity.

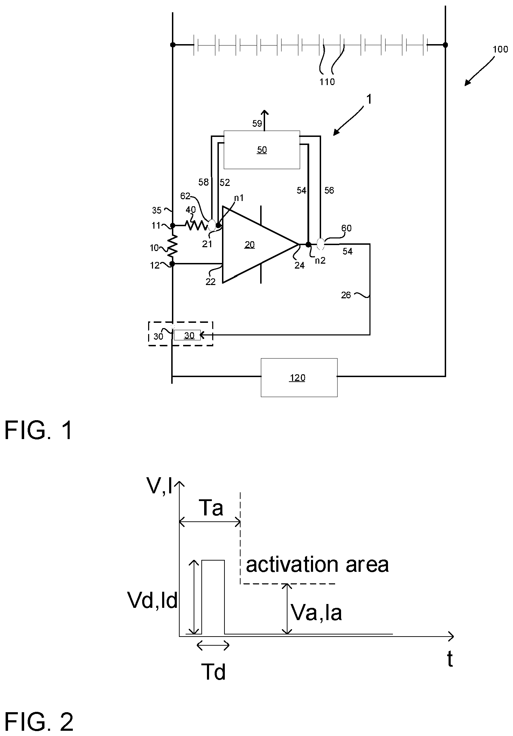

Fig. 1 shows a pyro igniter circuit 1 according to an embodiment of the present invention. Further, a battery system 100 is disclosed which includes the pyro igniter circuit 1. The pyro igniter circuit 1 comprises a shunt resistor 10 which is connected in series with a power line 35. The shunt resistor 10 may be a low impedance shunt. For example, the shunt resistor 10 may have a resistance of less than 100 µΩ or less than 500 µΩ, but the invention is not restricted thereto.

The power line 35 may be connected to a plurality of battery cells 110 of the battery system 100. In this particular example, the battery cells 110 are electrically connected in series with each other and parallel to the power line 35, but the invention is not restricted thereto. The plurality of battery cells 100 may provide power to the power line 35 in terms of an electrical voltage and an electrical current. The battery cells 110 of the battery system 100 may also be charged via the power line 35. The provided voltage may be up to 400V or even up to 800V in total, for example, and 4 V per battery cell 110, for example, but the invention is not restricted thereto. The number of battery cells 110 is provided only as example, but the invention is not restricted thereto. A load 120 may be electrically connected to the power line 35 to be supplied with the power from the battery cells 110. A load 120 may be any suitable component of an electrical vehicle requiring electric power.

The pyro igniter circuit 1 comprises an amplifier 20. The amplifier 20 comprises inputs 21, 22 electrically connected to terminals 11, 12 of the shunt resistor 10. The amplifier 20 has the function to provide an ignitor control signal 54 based on a (voltage) signal that is transmitted to the inputs 21, 22 of the amplifier 20. The amplifier 20 may be supplied with power to provide the amplifying function.

The pyro igniter circuit 1 further comprises a pyro igniter disconnect element 30. The pyro igniter disconnect element 30 may comprise passive and/or active electronic elements. For example, the pyro igniter disconnect element may comprise an ignition wire or heating wire. In further embodiments, the pyro igniter disconnect element may comprise internal transistors as active electronic elements. The pyro igniter disconnect element 30 is electrically connected to an output 24 of the amplifier 20. The pyro igniter disconnect element 30 cuts or isolates the power line 35 based on an ignition control signal 54 received from the output 24 of the amplifier 20. The pyro igniter disconnect element may be referred to as pyro-fuse or pyro-fuse element.

When a current above a threshold current flows through the shunt resistor 10, a voltage drops off at the terminals 11, 12 of the shunt resistor 10 and thus at the inputs 21, 22 of the amplifier 20. Such situations occur in severe system faults or short circuits. The ignition control signal 54 is then generated by the amplifier 20. Only when the ignition control signal 54 comprises sufficient amplitude and pulse duration sufficient energy is transferred to release or activate the pyro igniter disconnect element which will eventuate in a cut or an isolation of the power line 35 due to a pyro reaction. Then, the load 120 is isolated from the power line 35.

The pyro igniter circuit 1 further comprises a coupling resistor 40 electrically interconnected between a first input 21 of the amplifier 20 and a first terminal 11 of the shunt resistor 10. The coupling resistor 40 may have a resistance of 1 to 10 kΩ or 1 to 100 kΩ, but the invention is not restricted thereto.

Further, the pyro igniter circuit 1 comprises a supervisory circuit 50. The supervisory circuit 50 is electrically connected to a first node n1, wherein the first node n1 is interconnected between a first input 21 of the amplifier 20 and the coupling resistor 40. The supervisory circuit 50 is configured to transmit a test signal 52 to the first node n1. The supervisory circuit 50 generates a test signal 52 according to the following alternatives as illustrated in Fig. 2.

The test signal 52 may be voltage pulse signal or a current pulse signal.

In a first alternative, the generated test signal 52 comprises a pulse duration time Td below an igniter activation pulse time Ta of the pyro igniter disconnect element 30. The case where the pulse duration time Td is below an igniter activation pulse time Ta of the pyro igniter disconnect element 30 can be readily controlled by the supervisory circuit 50 by controlling only the pulse duration when the test signal 52 is generated. As can be viewed in Fig. 2, when the pulse duration time Td is below an igniter activation pulse time Ta, the corresponding ignition control signal 54 cannot release or activate the pyro igniter disconnect element 30 even in case the amplitude Vd, Id is above an igniter activation amplitude Va, la of the pyro igniter disconnect element 30, see e.g. Fig. 2. The activation area is schematically shown by dashed lines. Therefore, the pyro igniter circuit 1 can be completely tested by the test signal 52. The test can be done without dead time since an over current event can always trigger the pyro igniter disconnect element 30. The pulse duration time Td may be below 20 µs, preferably below 10 µs, more preferably below 1 µs to ensure that the pulse is short enough to activate the pyro igniter disconnect element 30. The pulse duration time Td may be for example 1/10, 1/100 or 1/1000 of the igniter activation pulse time Ta.

In a second alternative, the test signal 52 is generated by the supervision circuit 50 such that the ignition control signal 54 in response to the transmitted test signal 52 comprises an amplitude Va, la below an igniter activation amplitude Va, la of the pyro igniter disconnect element 30, see also here Fig. 2 for illustration. Here, the test signal 52 may be generated based on a pre-known amplifying strength of the amplifier 20. In such case, a pulse duration time Td may be below or above an igniter activation pulse time Ta of the pyro igniter disconnect element 30. In this case, the amplitudes Va, la may be too small to activate or release the pyro igniter disconnect element 30, see Fig. 2.

In a further embodiment, both cases are fulfilled. That is, the generated test signal 52 comprises a pulse duration time Td below an igniter activation pulse time Ta of the pyro igniter disconnect element 30 and the test signal 52 is generated such that the ignition control signal 54 in response to the transmitted test signal 52 comprises an amplitude Vd, Id below an igniter activation amplitude Va, la of the pyro igniter disconnect element 30, see also here Fig. 2 for illustration, in particular the activation area.

The supervisory circuit 50 after transmitting the test signal 52 further receives a diagnostic response signal 54, 56, 58 in response to the transmitted test signal 52, for example in a short time delay after transmission or in other words in a consecutive time window after the transmission of the test signal 52. Examples of particular diagnostic response signals 54, 56, 58 are provided below. When the test signal 52 fulfills that for example the pulse duration time Td is below an igniter activation pulse time Ta, as indicated in Fig. 2 for example, the pyro igniter disconnect element 30 does not activate or release, see Fig. 2 and above for the other cases. Therefore, the functionality of the complete pyro igniter circuit 1 can be tested. Further, the testing does not interfere with the functionality of the pyro igniter circuit 1, since at all times an over current can activate the pyro disconnect element 30. Further, the testing is fast and analogue without a slow software interaction. Further, the test pulse can be readily adjustable such that amplitude or pulse duration can be adjusted to the requirements of the underlying pyro igniter circuit.

The supervisory circuit 50 may be electrically connected to the output 24 of the amplifier 20. For example, supervisory circuit 50 may be electrically connected to a second node n2 of an output line 26 connected to the amplifier output 24. The supervisory circuit 50 may thus receive the ignition control signal 54 in response to the transmitted test signal 52 to the first node n1. In particular, the amplified voltage Vd of the amplified test signal 52 may be transmitted to the supervisory circuit 50. Thereby, the functionality of the amplifier 20, for example the correct gain, the connections or the power supply to the amplifier 20 may be checked when the ignition control signal 54 is received by the supervisory circuit 50.

The pyro igniter circuit 1 may comprise a first current sensor 60. The first current sensor 60 may be configured to measure an electric current on the output line 26 between the output 24 of the amplifier 20 and the pyro igniter disconnect element 30. The first current sensor 60 may transmit a first current signal 56 indicative of the measured electric current to the supervisory circuit 50. The measured current may be a direct indicator of the functionality and presence of the pyro igniter disconnect element 30, the latter schematically shown without a detailed internal structure in Fig. 1. For example, the measured current is low or minimized when the pyro igniter disconnect element 30 has a fault, is not present, has already been activated or one of the components therein like transistors (not shown) are functioning incorrectly.

The pyro igniter circuit 1 may comprise a second current sensor 62. The second current sensor 62 may be configured to measure an electric current on the first node n1 that is interconnected between the first input 21 and the coupling resistor 40. The current may be measured in response to the transmitted test signal 52. The second current sensor 62 may transmit the second current signal 58 indicative of the measured electric current to the supervisory circuit 50. Thereby, the functionality of the shunt resistor 10 may be checked since a current can only flow when the shunt resistor 10 is correctly connected since the current cannot flow into the amplifier 20. The first current sensor 60 and the second current sensor 62 may be any suitable sensor means to sense currents

Regarding to Fig. 2, in embodiments of the invention, the ignition control signal 54 in response to the transmitted test signal 52 may comprise an amplitude Vd, Id above an igniter activation amplitude Va, Ia of the pyro igniter disconnect element 30 while the pulse duration time Td is below an igniter activation pulse time Ta. In such case, also no activation or release of the pyro igniter disconnect element 30 may be caused.

In an alternative embodiment (not shown) of the invention, the ignition control signal 54 in response to the transmitted test signal 52 may comprise an amplitude Vd, Id below an igniter activation amplitude Va, Ia of the pyro igniter disconnect element 30 while the pulse duration time Td is above an igniter activation pulse time Ta. The amplitude Vd may be a voltage or a current Id.

The supervisory circuit 50 may further be configured to compare the received diagnostic response signal 54, 56, 58 with the transmitted test signal 52. Thereby the supervisory circuit 50 can detect any faults of the entire pyro igniter circuit as disclosed above.

The supervisory circuit 50 may further generate a state signal 59 based on the comparison of the diagnostic response signal 54, 56, 58 and the transmitted test signal 52. The state signal 59 may be used to for disconnecting or shutting down of the battery or for warning purposes.

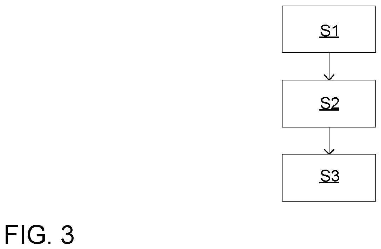

Figure 3 schematically shows a testing method for testing a pyro igniter circuit according to an embodiment of the invention. In a step S1 the method comprises providing a shunt resistor 10 connected in series with a power line 35, an amplifier 20 comprising inputs 21, 22 electrically connected to terminals 11, 12 of the shunt resistor 10, a pyro igniter disconnect element 30 electrically connected to an output 24 of the amplifier 20 and configured to cut the power line 35 based on an ignition control signal 54 received from the output 24 of the amplifier 20, a coupling resistor 40 electrically interconnected between a first input 21 of the amplifier 20 and a terminal 11 of the shunt resistor 10. In a step S2 the method comprises transmitting a test signal 52 to a node n1 interconnected between a first input 21 of the amplifier 20 and the coupling resistor 40, wherein the test signal 52 has a pulse duration time Td below an igniter activation pulse time Ta of the pyro igniter disconnect element 30 and/or the ignition control signal 54 in response to the transmitted test signal 52 comprises an amplitude Vd, Id below an igniter activation amplitude Va, Ia of the pyro igniter disconnect element 30.

In a third step S3 the method comprises receiving a diagnostic response signal 54, 56, 58 in response to the transmitted test signal 52.

Further aspects of the schematically disclosed method are disclosed in the above description of the corresponding pyro igniter circuit 1 and are hereby referenced to.

The electronic or electric devices and/or any other relevant devices or components according to embodiments of the present invention described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the exemplary embodiments of the present invention.

### Reference signs

- 1: pyro igniter circuit

- 10: shunt resistor
- 11: first terminal
- 12: second terminal

- 20: amplifier
- 21: first input
- 22: second input
- 24: output
- 26: output line

- 30: pyro igniter disconnect element
- 35: power line

- 40: coupling resistor

- 50: supervisory circuit
- 52: test signal
- 54: ignition control signal
- 56: first current signal
- 58: second current signal

- 60: first current sensor
- 62: second current sensor

- Td: pulse duration time
- Ta: igniter activation pulse time

- Vd: voltage amplitude
- Id: current amplitude
- Va: igniter activation voltage amplitude
- Ia: igniter activation current amplitude

- 100: battery system
- 110: battery cells
- 120: load

- n1: first node
- n2: second node

- S1: first step
- S2: second step
- S3: third step

## Claims

1. A pyro igniter circuit (1), comprising:
- a shunt resistor (10) connected in series with a power line (35);
- an amplifier (20) comprising inputs (21, 22) electrically connected to terminals (11, 12) of the shunt resistor (10);
- a pyro igniter disconnect element (30) electrically connected to an output (24) of the amplifier (20) and configured to cut the power line (35) based on an ignition control signal (54) received from the output (24) of the amplifier (20);
the pyro igniter circuit being **characterized by** further comprising
- a coupling resistor (40) electrically interconnected between an input (21) of the amplifier (20) and a terminal (11) of the shunt resistor (10);
- a supervisory circuit (50) electrically connected to a node (n1) interconnected between an input (21) of the amplifier (20) and the coupling resistor (40), configured to:
transmit a test signal (52) to the node (n1), wherein the test signal (52) comprises a pulse duration time (Td) below an igniter activation pulse time (Ta) of the pyro igniter disconnect element (30) and/or the ignition control signal (54) in response to the transmitted test signal (52)comprises an amplitude (Vd, Id) below an igniter activation amplitude (Va, la) of the pyro igniter disconnect element (30); and
receive a diagnostic response signal (54, 56, 58) in response to the transmitted test signal (52).

2. The pyro igniter circuit (1) of claim 1, wherein the supervisory circuit (50) is electrically connected to the output (24) of the amplifier (20) to receive the ignition control signal (54) in response to the transmitted test signal (52).

3. The pyro igniter circuit (1) of one of the claims 1 to 2, further comprising a first current sensor (60) configured to measure an electric current on an output line (26) between the output (24) of the amplifier (20) and the pyro igniter disconnect element (30) and transmit a first current signal (56) indicative of the measured electric current to the supervisory circuit (50).

4. The pyro igniter circuit (1) of one of the claims 1 to 3, further comprising a second current sensor (62) configured to measure an electric current at the node (n1) in response to the transmitted test signal (52) and transmit a second current signal (58) indicative of the measured electric current to the supervisory circuit (50).

5. The pyro igniter circuit (1) of one of the claims 1 to 4, wherein the pulse duration time (Td) is below 20 µs, preferably below 10 µs, more preferably below 1 µs.

6. The pyro igniter circuit (1) of one of the claims 1 to 5, wherein the test signal (52) comprises a pulse duration time (Td) below an igniter activation pulse time (Ta) of the pyro igniter disconnect element (30) and the ignition control signal (54) in response to the transmitted test signal (52) comprises an amplitude (Vd, Id) above an igniter activation amplitude (Va, la) of the pyro igniter disconnect element (30).

7. The pyro igniter circuit (1) of one of the claims 1 to 5, wherein the test signal (52) comprises a pulse duration time (Td) above an igniter activation pulse time (Ta) of the pyro igniter disconnect element (30) and the ignition control signal (54) in response to the transmitted test signal (52) comprises an amplitude (Vd, Id) below an igniter activation amplitude (Va, la) of the pyro igniter disconnect element (30).

8. The pyro igniter circuit (1) of one of the claims 1 to 7, wherein the supervisory circuit (50) is configured to compare the received diagnostic response signal (54, 56, 58) with the transmitted test signal (52).

9. The pyro igniter circuit (1) of claim 8, wherein the supervisory circuit (50) is configured to generate a state signal (59) based on the comparison of the diagnostic response signal (54, 56, 58) and the transmitted test signal (52).

10. A testing method for testing a pyro igniter circuit, comprising:
- providing a shunt resistor (10) connected in series with a power line (35), an amplifier (20) comprising inputs (21, 22) electrically connected to terminals (11, 12) of the shunt resistor (10), a pyro igniter disconnect element (30) electrically connected to an output (24) of the amplifier (20) and configured to cut the power line (35) based on an ignition control signal (54) received from the output (24) of the amplifier (20), a coupling resistor (40) electrically interconnected between an input (21) of the amplifier (20) and a terminal (11) of the shunt resistor (10);
- transmitting a test signal (52) to a node (n1) interconnected between an input (21) of the amplifier (20) and the coupling resistor (40), wherein the test signal (52) comprises a pulse duration time (Td) below an igniter activation pulse time (Ta) of the pyro igniter disconnect element (30) and/or the ignition control signal (54) in response to the transmitted test signal (52) comprises an amplitude (Vd, Id) below an igniter activation amplitude (Va, Ia) of the pyro igniter disconnect element (30); and
- receiving a diagnostic response signal (54, 56, 58) in response to the transmitted test signal (52).

11. The method of claim 10, receiving the ignition control signal (54) from the output (24) of the amplifier (20) in response to the transmitted test signal (52).

12. The method of one of the claims 10 to 11, measuring an electric current on an output line (26) between the output (24) of the amplifier (20) and the pyro igniter disconnect element (30) in response to the transmitted test signal (52) and transmit a first current signal (56) indicative of the measured electric current to the supervisory circuit (50).

13. The method of one of the claims 10 to 12, measuring an electric current at the node (n1) in response to the transmitted test signal (52) and transmit a second current signal (58) indicative of the measured electric current to the supervisory circuit (50).

14. A battery system (100), comprising a pyro igniter circuit (1) according to one of the claims 1 to 9 and a plurality of battery cells (110) electrically connected to the power line (35).

15. An electric vehicle comprising a battery system (14) according to claim 14.

## Patentansprüche

1. Pyrozünderschaltung (1), umfassend:
- einen Nebenschlusswiderstand (10), der mit einer Stromleitung (35) in Reihe geschaltet ist;
- einen Verstärker (20), umfassend Eingänge (21, 22), die elektrisch mit Klemmen (11, 12) des Nebenschlusswiderstands (10) verbunden sind;
- ein Pyrozündertrennelement (30), das elektrisch mit einem Ausgang (24) des Verstärkers (20) verbunden und so konfiguriert ist, dass es die Stromleitung (35) anhand eines vom Ausgang (24) des Verstärkers (20) empfangenen Zündsteuersignals (54) unterbricht;
die Pyrozünderschaltung, **dadurch gekennzeichnet, dass** sie ferner umfasst
- einen Kopplungswiderstand (40), der elektrisch zwischen einem Eingang (21) des Verstärkers (20) und einer Klemme (11) des Nebenschlusswiderstands (10) geschaltet ist;
- eine Überwachungsschaltung (50), die elektrisch mit einem Knoten (n1) verbunden ist, der zwischen einem Eingang (21) des Verstärkers (20) und dem Kopplungswiderstand (40) liegt und die konfiguriert ist zum:
Übertragen eines Testsignals (52) an den Knoten (n1), wobei das Testsignal (52) eine Impulsdauerzeit (Td) unterhalb einer Zünderaktivierungsimpulszeit (Ta) des Pyrozündertrennelements (30) umfasst und/oder das Zündsteuersignal (54) als Reaktion auf das übertragene Testsignal (52) eine Amplitude (Vd, Id) unterhalb einer Zünderaktivierungsamplitude (Va, la) des Pyrozündertrennelements (30) umfasst; und Empfangen eines Diagnoseantwortsignals (54, 56, 58) als Reaktion auf das übertragene Testsignal (52).

2. Pyrozünderschaltung (1) nach Anspruch 1, wobei die Überwachungsschaltung (50) elektrisch mit dem Ausgang (24) des Verstärkers (20) verbunden ist, um das Zündsteuersignal (54) als Reaktion auf das übertragene Testsignal (52) zu empfangen.

3. Pyrozünderschaltung (1) nach einem der Ansprüche 1 bis 2, ferner umfassend einen ersten Stromsensor (60), der so konfiguriert ist, dass er einen elektrischen Strom auf einer Ausgangsleitung (26) zwischen dem Ausgang (24) des Verstärkers (20) und dem Pyrozündertrennelement (30) misst und ein erstes Stromsignal (56), das den gemessenen elektrischen Strom anzeigt, an die Überwachungsschaltung (50) überträgt.

4. Pyrozünderschaltung (1) nach einem der Ansprüche 1 bis 3, ferner umfassend einen zweiten Stromsensor (62), der so konfiguriert ist, dass er als Reaktion auf das übertragene Testsignal (52) einen elektrischen Strom am Knoten (n1) misst und ein zweites Stromsignal (58), das den gemessenen elektrischen Strom anzeigt, an die Überwachungsschaltung (50) überträgt.

5. Pyrozünderschaltung (1) nach einem der Ansprüche 1 bis 4, wobei die Impulsdauerzeit (Td) unter 20 ps, vorzugsweise unter 10 ps, besonders bevorzugt unter 1 ps liegt.

6. Pyrozünderschaltung (1) nach einem der Ansprüche 1 bis 5, wobei das Testsignal (52) eine Impulsdauerzeit (Td) unterhalb einer Zünderaktivierungsimpulszeit (Ta) des Pyrozündertrennelements (30) umfasst und das Zündsteuersignal (54) als Reaktion auf das übertragene Testsignal (52) eine Amplitude (Vd, Id) oberhalb einer Zünderaktivierungsamplitude (Va, la) des Pyrozündertrennelements (30) umfasst.

7. Pyrozünderschaltung (1) nach einem der Ansprüche 1 bis 5, wobei das Testsignal (52) eine Impulsdauerzeit (Td) oberhalb einer Zünderaktivierungsimpulszeit (Ta) des Pyrozündertrennelements (30) umfasst und das Zündsteuersignal (54) als Reaktion auf das übertragene Testsignal (52) eine Amplitude (Vd, Id) unterhalb einer Zünderaktivierungsamplitude (Va, la) des Pyrozündertrennelements (30) umfasst.

8. Pyrozünderschaltung (1) nach einem der Ansprüche 1 bis 7, wobei die Überwachungsschaltung (50) so konfiguriert ist, dass sie das empfangene Diagnoseantwortsignal (54, 56, 58) mit dem übertragenen Testsignal (52) vergleicht.

9. Pyrozünderschaltung (1) nach Anspruch 8, wobei die Überwachungsschaltung (50) so konfiguriert ist, dass sie ein Zustandssignal (59) anhand des Vergleichs des Diagnoseantwortsignals (54, 56, 58) und des übertragenen Testsignals (52) erzeugt.

10. Testverfahren zum Testen einer Pyrozünderschaltung, umfassend:
- Bereitstellen eines Nebenschlusswiderstands (10), der mit einer Stromleitung (35) in Reihe geschaltet ist, eines Verstärkers (20), umfassend Eingänge (21, 22), die elektrisch mit Anschlüssen (11, 12) des Nebenschlusswiderstands (10) verbunden sind, ein Pyrozündertrennelement (30), das elektrisch mit einem Ausgang (24) des Verstärkers (20) verbunden und so konfiguriert ist, dass es die Stromleitung (35) anhand eines Zündsteuersignals (54) unterbricht, das von dem Ausgang (24) des Verstärkers (20) empfangen wird, einen Kopplungswiderstand (40), der elektrisch zwischen einen Eingang (21) des Verstärkers (20) und einen Anschluss (11) des Nebenschlusswiderstands (10) geschaltet ist;
- Übertragen eines Testsignals (52) an einen Knoten (n1), der zwischen einem Eingang (21) des Verstärkers (20) und dem Kopplungswiderstand (40) geschaltet ist, wobei das Testsignal (52) eine Impulsdauerzeit (Td) unterhalb einer Zünderaktivierungsimpulszeit (Ta) des Pyrozündertrennelements (30) umfasst und/oder das Zündsteuersignal (54) als Reaktion auf das übertragene Testsignal (52) eine Amplitude (Vd, Id) unterhalb einer Zünderaktivierungsamplitude (Va, la) des Pyrozündertrennelements (30) umfasst; und
- Empfangen eines Diagnoseantwortsignals (54, 56, 58) als Reaktion auf das übertragene Testsignal (52) .

11. Verfahren nach Anspruch 10, wobei das Zündsteuersignal (54) vom Ausgang (24) des Verstärkers (20) als Reaktion auf das übertragene Testsignal (52) empfangen wird.

12. Verfahren nach einem der Ansprüche 10 bis 11, wobei ein elektrischer Strom auf einer Ausgangsleitung (26) zwischen dem Ausgang (24) des Verstärkers (20) und dem Pyrozündertrennelements (30) als Reaktion auf das übertragene Testsignal (52) gemessen und ein erstes Stromsignal (56), das den gemessenen elektrischen Strom anzeigt, an die Überwachungsschaltung (50) übertragen wird.

13. Verfahren nach einem der Ansprüche 10 bis 12, wobei als Reaktion auf das übertragene Testsignal (52) ein elektrischer Strom am Knoten (n1) gemessen und ein zweites Stromsignal (58), das den gemessenen elektrischen Strom anzeigt, an die Überwachungsschaltung (50) übertragen wird.

14. Batteriesystem (100), umfassend eine Pyrozünderschaltung (1) nach einem der Ansprüche 1 bis 9 und eine Vielzahl von Batteriezellen (110), die elektrisch mit der Stromleitung (35) verbunden sind.

15. Elektrofahrzeug, umfassend ein Batteriesystem (14) nach Anspruch 14.

## Revendications

1. Circuit d'allumeur Pyro (1), comprenant :
- une résistance shunt (10) connectée en série à une ligne électrique (35) ;
- un amplificateur (20) comprenant des entrées (21, 22) connectées électriquement à des bornes (11, 12) de la résistance shunt (10) ;
- un élément de déconnexion d'allumeur Pyro (30) connecté électriquement à une sortie (24) de l'amplificateur (20) et configuré pour couper la ligne électrique (35) sur la base d'un signal de commande d'allumage (54) reçu à partir de la sortie (24) de l'amplificateur (20) ;
le circuit d'allumeur Pyro étant **caractérisé en ce qu'**il comprend en outre
- une résistance de couplage (40) interconnectée électriquement entre une entrée (21) de l'amplificateur (20) et une borne (11) de la résistance shunt (10) ;
- un circuit de supervision (50) connecté électriquement à un nœud (n1) interconnecté entre une entrée (21) de l'amplificateur (20) et la résistance de couplage (40), configuré pour :
transmettre un signal de test (52) au nœud (n1), le signal de test (52) comprenant un temps de durée d'impulsion (Td) inférieur à un temps d'impulsion d'activation d'allumeur (Ta) de l'élément de déconnexion d'allumeur Pyro (30), et/ou le signal de commande d'allumage (54) en réponse au signal de test (52) transmis comprenant une amplitude (Vd, Id) inférieure à une amplitude d'activation d'allumeur (Va, la) de l'élément de déconnexion d'allumeur Pyro (30) ; et
recevoir un signal de réponse de diagnostic (54, 56, 58) en réponse au signal de test (52) transmis.

2. Circuit d'allumeur Pyro (1) selon la revendication 1, dans lequel le circuit de supervision (50) est connecté électriquement à la sortie (24) de l'amplificateur (20) pour recevoir le signal de commande d'allumage (54) en réponse au signal de test (52) transmis.

3. Circuit d'allumeur Pyro (1) selon l'une des revendications 1 et 2, comprenant en outre un premier capteur de courant (60) configuré pour mesurer un courant électrique sur une ligne de sortie (26) entre la sortie (24) de l'amplificateur (20) et l'élément de déconnexion d'allumeur Pyro (30) et transmettre un premier signal de courant (56) indicatif du courant électrique mesuré au circuit de supervision (50).

4. Circuit d'allumeur Pyro (1) selon l'une des revendications 1 à 3, comprenant en outre un deuxième capteur de courant (62) configuré pour mesurer un courant électrique au niveau du nœud (n1) en réponse au signal de test (52) transmis et transmettre un deuxième signal de courant (58) indicatif du courant électrique mesuré au circuit de supervision (50).

5. Circuit d'allumeur Pyro (1) selon l'une des revendications 1 à 4, dans lequel le temps de durée d'impulsion (Td) est inférieur à 20 µs, de préférence inférieur à 10 µs, de manière davantage préférée inférieur à 1 µs.

6. Circuit d'allumeur Pyro (1) selon l'une des revendications 1 à 5, dans lequel le signal de test (52) comprend un temps de durée d'impulsion (Td) inférieur à un temps d'impulsion d'activation d'allumeur (Ta) de l'élément de déconnexion d'allumeur Pyro (30) et le signal de commande d'allumage (54) en réponse au signal de test (52) transmis comprend une amplitude (Vd, Id) supérieure à une amplitude d'activation d'allumeur (Va, Ia) de l'élément de déconnexion d'allumeur Pyro (30).

7. Circuit d'allumeur Pyro (1) selon l'une des revendications 1 à 5, dans lequel le signal de test (52) comprend un temps de durée d'impulsion (Td) supérieur à un temps d'impulsion d'activation d'allumeur (Ta) de l'élément de déconnexion d'allumeur Pyro (30), et le signal de commande d'allumage (54) en réponse au signal de test (52) transmis comprend une amplitude (Vd, Id) inférieure à une amplitude d'activation d'allumeur (Va, Ia) de l'élément de déconnexion d'allumeur Pyro (30).

8. Circuit d'allumeur Pyro (1) selon l'une des revendications 1 à 7, dans lequel le circuit de supervision (50) est configuré pour comparer le signal de réponse de diagnostic (54, 56, 58) reçu avec le signal de test (52) transmis.

9. Circuit d'allumeur Pyro (1) selon la revendication 8, dans lequel le circuit de supervision (50) est configuré pour générer un signal d'état (59) sur la base de la comparaison du signal de réponse de diagnostic (54, 56, 58) et du signal de test (52) transmis.

10. Procédé de test pour tester un circuit d'allumeur Pyro, comprenant les étapes consistant à :
- fournir une résistance shunt (10) connectée en série à une ligne électrique (35), un amplificateur (20) comprenant des entrées (21, 22) connectées électriquement à des bornes (11, 12) de la résistance shunt (10), un élément de déconnexion d'allumeur Pyro (30) connecté électriquement à une sortie (24) de l'amplificateur (20) et configuré pour couper la ligne électrique (35) sur la base d'un signal de commande d'allumage (54) reçu à partir de la sortie (24) de l'amplificateur (20), une résistance de couplage (40) interconnectée électriquement entre une entrée (21) de l'amplificateur (20) et une borne (11) de la résistance shunt (10) ;
- transmettre un signal de test (52) à un nœud (n1) interconnecté entre une entrée (21) de l'amplificateur (20) et la résistance de couplage (40), le signal de test (52) comprenant un temps de durée d'impulsion (Td) inférieur à un temps d'impulsion d'activation d'allumeur (Ta) de l'élément de déconnexion d'allumeur Pyro (30), et/ou le signal de commande d'allumage (54) en réponse au signal de test (52) transmis comprenant une amplitude (Vd, Id) inférieure à une amplitude d'activation d'allumeur (Va, Ia) de l'élément de déconnexion d'allumeur Pyro (30) ; et
- recevoir un signal de réponse de diagnostic (54, 56, 58) en réponse au signal de test (52) transmis.

11. Procédé selon la revendication 10, comprenant l'étape consistant à recevoir le signal de commande d'allumage (54) à partir de la sortie (24) de l'amplificateur (20) en réponse au signal de test (52) transmis.

12. Procédé selon l'une des revendications 10 et 11, comprenant les étapes consistant à mesurer un courant électrique sur une ligne de sortie (26) entre la sortie (24) de l'amplificateur (20) et l'élément de déconnexion d'allumeur Pyro (30) en réponse au signal de test (52) transmis et à transmettre un premier signal de courant (56) indicatif du courant électrique mesuré au circuit de supervision (50).

13. Procédé selon l'une des revendications 10 à 12, comprenant les étapes consistant à mesurer un courant électrique au niveau du nœud (n1) en réponse au signal de test (52) transmis et à transmettre un deuxième signal de courant (58) indicatif du courant électrique mesuré au circuit de supervision (50).

14. Système de batterie (100), comprenant un circuit d'allumeur Pyro (1) selon l'une des revendications 1 à 9 et une pluralité d'éléments de batterie (110) connectés électriquement à la ligne électrique (35).

15. Véhicule électrique comprenant un système de batterie (14) selon la revendication 14.
